# EUROPEAN PATENT SPECIFICATION

(11) **EP 0 757 615 B1**
(45) Date of publication and mention of the grant of the patent: **31.03.2004**
(21) Application number: 95917098.6
(22) Date of filing: 21.04.1995
(51) Int. Cl.: B26B 21/60, C23C 14/06

(54) **PROCESS OF COATING A LAYER OF AMORPHOUS DIAMOND ON BLADES**
VERFAHREN ZUM AMORPHEN DIAMANTBESCHICHTEN VON KLINGEN
PROCEDE DE REVETEMENT DE LAMES AVEC DU DIAMANT AMORPHE

(30) Priority: 25.04.1994 US 232928
(43) Date of publication of application: 12.02.1997
(60) Divisional application: 04000179.4
(73) Proprietor: THE GILLETTE COMPANY, Boston, Massachusetts 02199 (US)
(72) Inventor: DECKER, Thomas G., Arlington, MA 02154 (US); LUNDIE, Gregory P., Westminster, CO 80021 (US); PAPPAS, David L., Waltham, MA 02154 (US); WELTY, Richard P., Boulder, CO 80303 (US); PARENT, C. Robert, Westwood, MA 02090 (US)
(74) Representative: Ebner von Eschenbach, Jennifer
(86) International application number: PCT/US1995/004894
(87) International publication number: WO 1995/029044

(56) References cited:
- EP-A- 0 207 467
- EP-A- 0 509 875
- WO-A-87/04471
- WO-A-93/09921
- US-A- 5 032 243
- US-A- 5 232 568
- US-A- 5 279 723
- US-A- 5 295 305
- PATENT ABSTRACTS OF JAPAN vol. 13, no. 337 (P-906) 28 July 1989 & JP,A,01 097 839 (NIPPON STEEL CORP) 17 April 1989

## Description

This invention relates to improved processes for producing razor blades with sharp and durable cutting edges, wherein a layer of amorphous diamond coating is deposited on a substrate using a filtered cathodic arc plasma source according to the preamble of claim 1 (see, for example, US-A-5 295 305). The invention has particular utility for forming a very hard and rigid coating of high aspect ratio on very thin cutting edges of razor blades.

A razor blade typically is formed of suitable substrate material such as metal or ceramic, and an edge is formed with wedge-shape configuration with an ultimate edge or tip that has a radius of less than about 1,000 angstroms, the wedge shaped surfaces having an included angle of less than 30°. As shaving action is severe and blade edge damage frequently results and to enhance shavability, the use of one or more layers of supplemental coating material has been proposed for shave facilitation, and/or to increase the hardness and/or corrosion resistance of the shaving edge.

A number of such coating materials have been proposed, such as polymeric materials and metals, as well as other materials including diamond-like carbon (DLC) material. Each such layer or layers of supplemental material must have adhesion compatibility so that each layer remains firmly adhered to the substrate throughout the useful life of the razor blade, and desirably provide characteristics such as improved shavability, improved hardness and/or corrosion resistance while not adversely affecting the geometry and cutting effectiveness of the shaving edge.

United States Patent No. 5,032,243 of Bache et al. describes blade substrate materials sharpened by ion bombardment from ion sources having the axes of their beams directed at the edges of the razor blades. United States Patent No. 5,232,568 of Parent et al. and United States Patent No. 5,295,305 of Rahn et al. show blades which have an interlayer interposed between the substrate and the diamond-like coating, wherein the interlayer is deposited on the substrate and then the diamond-like coating is deposited on the interlayer. EP0207467 discloses forming a diamond-coated microtome blade by plasma induced vapor deposition in an atmosphere of a mixture of hydrocarbon compound and hydrogen, with the coating upgraded by a high temperature heat treatment.

The prior solutions are not entirely successful, and it would be desirable simply to use mechanical honing processes to form the sharpened substrate (rather than the ion beam formation shown in Bache et al.) followed by a direct deposition of amorphous diamond coating on the substrate (without the intervening step of depositing an interlayer). It would be desirable, therefore, to be able to start with a thin blade substrate produced by mechanical honing and to impart both rigidity and hardness to the substrate by depositing an amorphous diamond coating directly on the substrate.

In accordance with the invention, there is provided a process for forming a razor blade wherein a layer of amorphous diamond is deposited on a substrate, comprising the steps of providing a substrate, forming a wedge-shaped sharpened edge on the substrate that has an included angle of less than 30 degrees and a tip radius of less than 1,200 angstroms, depositing a layer of amorphous diamond on the sharpened edge, applying an initial high bias to the substrate during deposition and then applying a second lower bias to the substrate during deposition.

The cutting edges of razor blades are provided with improved, mechanical properties by applying to the sharpened edge of the substrate a coating of an amorphous diamond material. Such materials may be characterized as having at least 40 percent sp3 carbon bonding, a hardness of at least 45 gigapascals and a modulus of at least 400 gigapascals. In addition, such materials are not corroded by hot aqueous solutions and compounds commonly used in shaving. Materials having these characteristics will be denoted as amorphous diamond in the further course of this disclosure. In contrast to the amorphous diamond material of this invention, traditional diamond-like carbon coatings (DLC) produced by such traditional methods as sputtering do not exhibit such high hardnesses. Unlike the amorphous diamond of this disclosure, DLC coatings typically have hardnesses not exceeding 30 gigapascals.

The extreme hardness and rigidity of the applied amorphous diamond coaring can provide strength to a very thin razor blade edge. United States Patent No. 4,720,918 of Curry et al. describes edges of this type, and they are included here as examples and need not be considered limiting. A very thin blade edge can provide increased shaving comfort, but is practical only if the edge is strong enough to withstand shaving. A thin edge, including but not limited to those described in United States Patent No. 4,720,918, strengthened by 400 to 2000 angstroms of amorphous diamond will comprise a finished edge which is significantly thinner than edges presently used for shaving, coupled with sufficient strength to withstand shaving, this due to the extraordinary strength of the amorphous diamond coating.

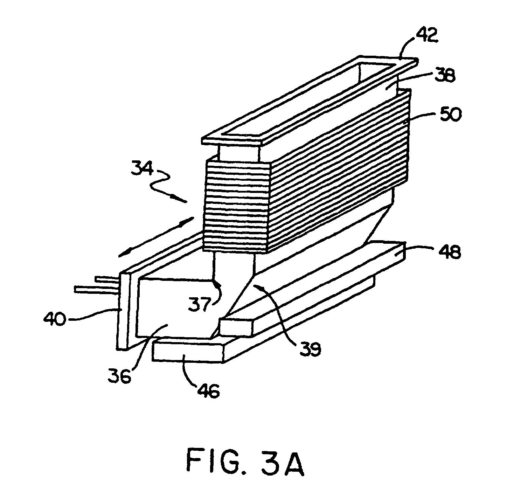

Further contributing to a thin edge is the large aspect ratio attainable by the particular cathodic arc deposition process used in this invention for manufacture of amorphous diamond coatings. The "aspect ratio" is explained in greater detail with reference to FIG. 3 in the discussion which follows, but may be understood for purposes of this summary as being the ratio of (a) to (b) where (a) is a first distance from the tip of the coating to the tip of the substrate, and (b) is a second distance from a surface of the coating to the tip of the substrate.

The aspect ratio provides a useful measure of the effect of a coating on the underlying blade edge geometry of the substrate -- the larger or higher the aspect ratio of the coating, the "sharper" is the coated blade compared to a blade coated at a lower aspect ratio. As a further consequence of the extraordinary strength of the amorphous diamond coatings of this invention, application of such a coating to a razor blade of normal cross-section will be expected to provide longer shaving life.

In accordance with one aspect of the invention, there is provided a wedge-shaped edge and a layer of amorphous diamond on the tip and flanks of the wedge-shaped edge, preferably with a thickness of at least 400 angstroms, which defines a tip radius of less than about 500 angstroms and an aspect ratio of 2:1 to 4:1. The blade exhibits excellent shaving properties and long life.

In a particular process, the substrate is mechanically abraded in a sequence of honing steps to form the sharpened edge; a layer of amorphous diamond is deposited by filtered cathodic arc, the amorphous diamond coating on the cutting edge having a thickness of at least 400 angstroms and an adherent polymer coating may be applied on the amorphous diamond coated cutting edge.

Other features and advantages of the invention, including process conditions for applying the desired amorphous diamond coating will be seen as the following description of particular embodiments progresses, in conjunction with the drawings.
FIG. 1 is a perspective view of a shaving unit in accordance with the invention;
FIG. 2 is a perspective view of another shaving unit in accordance with the invention;
FIG. 3 is a diagrammatic view illustrating one example of razor blade edge geometry in accordance with the invention;
FIG. 4 is a diagrammatic view of apparatus for the practice of the invention.

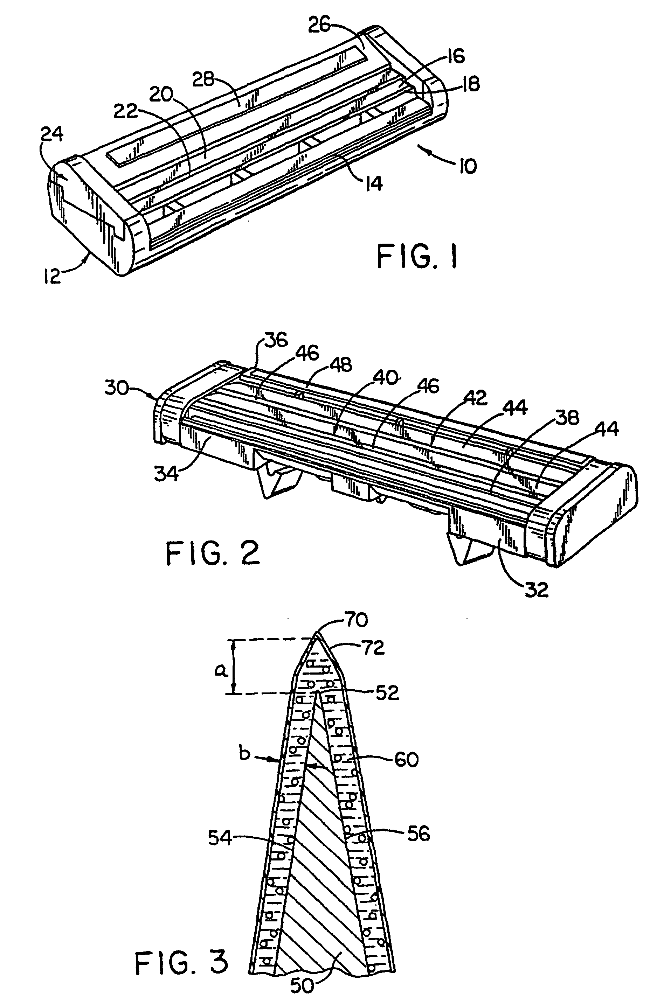

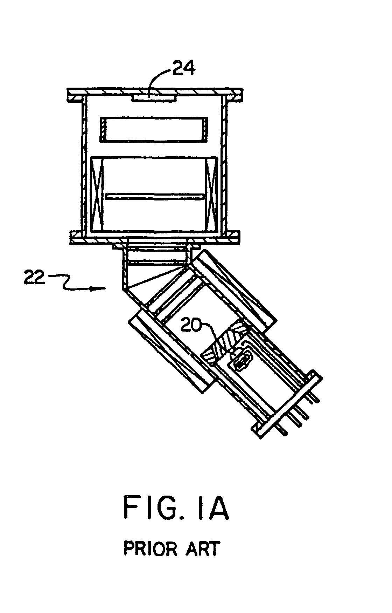

FIGS. 1A-6A are illustrations of United States Patent No. 5,480,527, hereinafter described.

In the description which follows, the characteristics and properties of various preferred embodiments of the blade, substrate and amorphous diamond coating will be disclosed, followed by a disclosure of process conditions for depositing the desired coating.

With reference to FIG. 1, shaving unit 10 includes structure for attachment to a razor handle, and a platform member 12 molded of high-impact polystyrene that includes structure defining forward, transversely-extending skin engaging surface 14. Mounted on platform member 12 are leading blade 16 having sharpened edge 18 and following blade 20 having sharpened edge 22. Cap member 24 of molded high-impact polystyrene has structure defining skin-engaging surface 26 that is disposed rearwardly of blade edge 22, and affixed to cap member 24 is shaving aid composite 28.

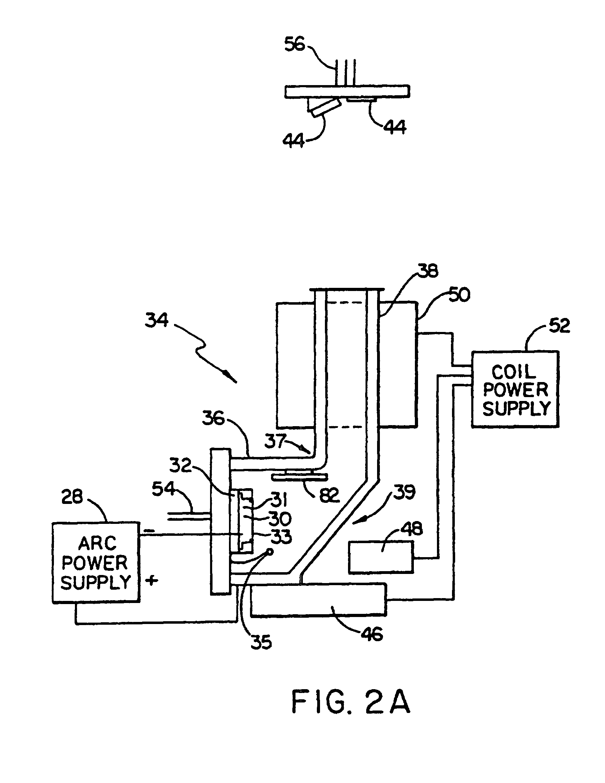

The shaving unit 30 shown in FIG. 2 is of the type shown in United States Patent No. 4,586,255 of Jacobson and includes molded body 32 with front portion 34 and rear portion 36. Resiliently secured in body 32 are guard member 38, leading blade unit 40 and trailing blade unit 42. Each blade unit 40, 42 includes a blade member 44 that has a sharpened edge 46. A shaving aid composite 48 is frictionally secured in a recess in rear portion 36.

A diagrammatic view of the edge region of the blades 16, 20 and 44 is shown in FIG. 3, from which the aspect ratio may be better understood. The blade includes stainless steel body portion 50 with a wedge-shaped sharpened edge formed in a sequence of edge forming honing operations that forms a tip portion 52 that has a radius typically less than 500 angstroms with facets 54 and 56 that diverge at an angle of about 13°. Deposited on tip 52 and facets 54, 56 is amorphous diamond 60 that has a thickness of about 2,000 angstroms, with an aspect ratio (the ratio at distance (a) from amorphous diamond tip 70 to stainless steel tip 52, and the width (b) of the amorphous diamond coating 60 to tip 52) of about 3:1.

Deposited on layer 60 is an adherent telomer layer 72 that has a substantial as deposited thickness but is reduced to monolayer thickness during initial shaving.

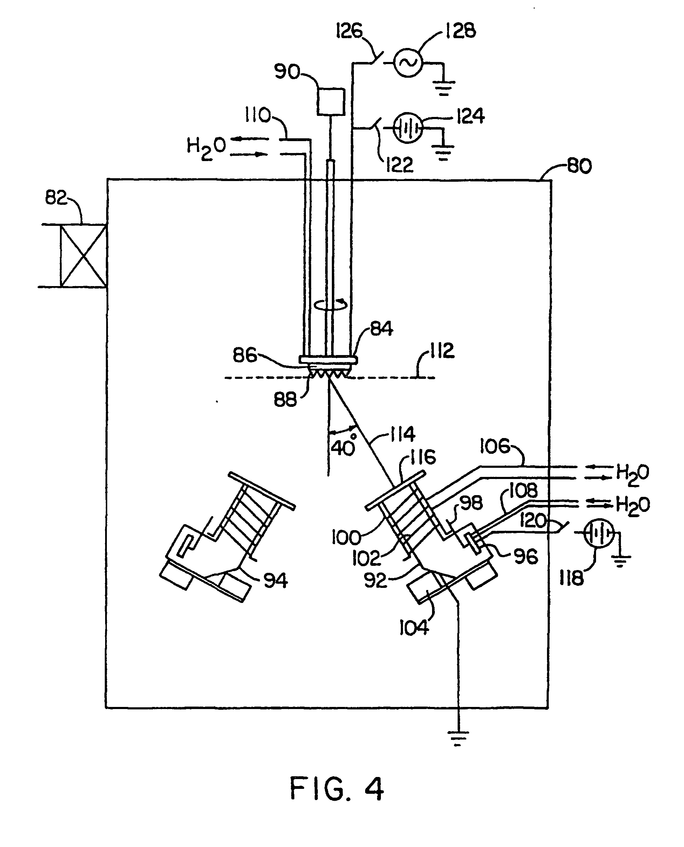

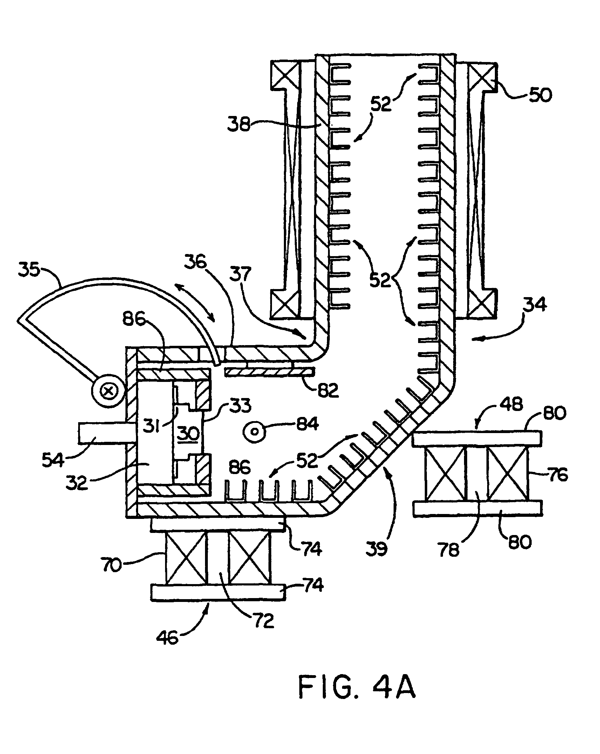

An apparatus for processing blades of the type shown in Fig. 3 is schematically illustrated in Fig. 4. That apparatus includes a filtered cathodic arc deposition system, such as one manufactured by Vapor Technologies of Boulder, Colorado that has stainless steel chamber 80 which is coupled to a vacuum pumping system (not shown) through valve 82. Mounted in chamber 80 is an electrically isolated, water cooled substrate platform 84 on which is disposed a rotatable fixture 86 which holds a stack of razor blades 88.

The sharpened edges are aligned perpendicularly to the plane of the drawing and face downward from the support 86. Motor 90 fixed outside the chamber 80 provides 180 degrees of rotation of the blade stack at predetermined intervals for the purpose of alternately exposing each blade edge to the beam of carbon ions from a single cathodic arc source 92, insuring uniform deposition on both blade bevels.

Also disposed in chamber 80 are two filtered cathodic arc sources 92, 94, each consisting of a graphite target 96 (cathode, 99.99% purity), an arc striking mechanism 98, and a filter or duct 100. The filter 100 serves to direct the flow of carbon ions (the arc plasma) from the cathode 96 to the blade stack 88, through the use of solenoidal magnetic fields produced by electrical windings 102 along the length of the duct and an electromagnet 104 positioned under the duct. The cathodic arc source may also be of the type described in, and the magnetic fields may be controlled so as to optimize the performance of the arc relative to the sources as described in co-pending United States Application No. 08/233,006 of Welty, filed April 25, 1994, the description of which is included in this application identified as Attachment A. Water cooling lines 106, 108 and 110 are provided for the target 96, duct 92 and blade support 86, respectively.

The duct is so directed to provide an angle of 40 degrees between the plane 112 presented by the blade tips and the center axis 114 of the duct exit 114. This angle is chosen to insure that a fully dense coating is deposited. The graphite target 96 is approximately 30 centimeters long by 2.5 centimeters wide and is electrically insulated from the chamber 80, while the duct 100 is at ground potential. The graphite target 96 is connected to a DC power supply 118 through switch 120. Electrical wiring is provided to connect blade stack 88 through switch 122 to DC power supply 124 or through switch 126 to RF power supply 128. The details of a preferred filtered cathodic arc design and operation are discussed further in the previously mentioned United States Patent No. 5,480,527 of Welty, repeated hereinbelow.

Rotatable mount 86 supports the blade stack 88 with edges spaced 15 centimeters from the mouth of the filter duct. The blade stack 88 is rotated between a position where one bevel faces the duct 92, and a similar position where the opposite bevel faces the duct 92. This rotation of 180 degrees is carried out every 10 seconds, insuring the bevels are coated equally.

In one example of a particular processing sequence, a stack of blades 88 (2.5 centimeters long) is secured on the rotatable mount 86, the support cooling water is turned on, and the chamber 80 is evacuated. The pressure to chamber 80 is adjusted to 50 millitorr with flowing argon. Switch 122 is closed to provide -400 volts DC to the blade stack, igniting a DC plasma discharge in which the blades are cleaned for ten minutes. After the cleaning step, (i) the pressure in the chamber is adjusted to 0.1 millitorr of argon, (ii) the field coils 102 to a single duct 92 are energized, (iii) switch 120 to graphite target 96 is closed, (iv) the power supply 124 to the blades is adjusted to -1000 volts DC, and (v) an arc is struck/initiated on graphite target 96 with mechanical striker 98. The arc current is set to 100 A. An intense plasma of carbon ions is emitted from duct 92 and is deposited on the blades 88, which rotate 180 degrees every 10 seconds.

After the arc has run for 2 minutes, the bias supply 124 is set to -50 volts and deposition continues for a total time of 16 minutes. The resultant amorphous diamond blade coating is approximately 1000 angstroms in thickness on each facet. The blade tip radius is approximately 350 angstroms, and the aspect ratio is approximately 2.5:1.

In another example of the processing sequence, the two cathodic arc sources are simultaneously operated, with the second source 94 positioned opposite the first source 92, so that both blade facets are simultaneously coated at approximately the same angle of incidence. In this case, the blade stack 88 is not rotated, but is rather translated through the region where the plasmas emitted from both sources intersect. All other aspects of the processing sequence are identical to those indicated above.

A coating 72 of polyterrafluorethylene (PTFE) telomer is then applied to the amorphous diamond coated edges of the blades. The process involves heating the blades in a neutral atmosphere of argon and providing on the cutting edges of the blades an adherent and friction-reducing polymer coating of solid PTFE. Coatings 72 and 60 were firmly adherent to the blade body 50, provided low wet wool felt cutter force (the lowest of the first five cuts with wet wool felt (L5) being about 0.45 kilogram), and withstood repeated applications of wool felt cutter forces indicating that the amorphous diamond coating 60 is substantially unaffected by exposure to the severe conditions of this felt cutter test and remains firmly adhered to the blade body 50, even after immersion in 80°C. distilled water for sixteen hours.

Resulting blade elements 44 were assembled in cartridge units 30 of the type shown in FIG. 2 and shaved with excellent shaving results.

### Process Conditions

The foregoing disclosure of the characteristics and properties of the blades, substrates and amorphous diamond coatings may be further understood and enhanced by the following specific description of suitable process conditions generally described above. First, the preferred cathodic arc sources will be summarized. Then various preferred process conditions will be described.

Cathodic Arc Source. A deposition coating of amorphous diamond may be applied using conventional filtered cathodic arc plasma source material as described in United States Patent No. 5,279,723 of Falabella et al. However, in a preferred embodiment, the deposition coating is applied according to the previously referenced co-pending application which is appended as Attachment A hereto. Although the rectangular source of Attachment A is particularly suited to the practice of this invention, the invention is not so limited. Likewise, an unfiltered or other conventional source may be used, and this invention should not be understood as being limited to filtered cathodic arc sources.

### Process Conditions and Adjustments.

Process conditions include a multi-step bias to the substrate; an equal average deposition on both sides of the blade; and attention to the angle of presentation.

An initial high bias in the range of 200-2000 volts is applied to the substrate during deposition for up to two minutes to establish adhesion. A second stage lower bias in the range of 10-200 volts is then applied to optimize the structure of the amorphous diamond hard carbon coating and to establish the desired crystal structure. Although at least the foregoing two stages are desirable according to this invention, it may also be desirable to provide a further "step down" incremental bias voltage reduction as, for example by adding an intermediate bias stage at 500 volts.

The amorphous diamond deposition is laid down at an equal average rate (or simultaneously) on both sides of the blade. By setting at least dual sources for simultaneous deposition and/or cycling the angle of presentation of the blade set relative to the deposition source, the coating layer will be applied equally or at an equal average rate of deposit, on both sides. In light of the fact that the blades each have a cutting edge bounded by a first inclined surface and a second inclined surface, coming to a tip at the juncture of the inclined surfaces and that a set of blades:
- may be disposed as a stack of blades presenting a plane surface formed by the tips, or
- may be disposed in a carousel, or otherwise;
the layered concept involves either (i) using at least two sources so that the deposition rate is instantaneously equal on both sides of the cutting edge, or (ii) employing a movement of the blade set (stack or carousel) relative to a single source (a cyclic alternation of the presentation of the blades with respect to the source, as by a flipping of the stack, a rotation of the carousel, or other sequential presentation) in order that a coating will be laid down on both sides of the cutting edge of each razor at an approximately equal rate over time.

That is, in order to apply a coating of 1000 angstroms in thickness, a preferred method of this invention would not lay down all 1000 angstroms on the first side and then lay down all 1000 angstroms on the second side of a blade stack -- instead, it would be either (i) a simultaneous deposition on both sides or (ii) a cyclic alternation in a range of 3 to 500 angstroms on the first side then 3 to 500 angstroms on the second side, and so on until the 1000 angstrom or other desired thickness is built on both sides of the cutting edge of each blade. While the foregoing is a preferred method, the invention is not to be understood as so limited, and may be practiced with an uneven or unbalanced layering.

It should be understood that the angle of presentation is of some concern. The low pressure (high vacuum) conditions produce a highly directional plasma stream of ionized carbon. The blades are presented at an angle measured from a line normal to the plane formed by the tips of the stacked blades (or measured from the line bisecting the angle enclosed by the tip and the first and second inclined surfaces of the cutting edge of an unstacked blade) that is greater that 20° but less than 90°. The angle of presentation is intended to direct the plasma stream more directionally against one or the other sides of the cutting edges of the blades.

As is conventionally known, the deposition process of this invention may be operated with or without a process gas such as argon; cleaning of the chamber may be accomplished with RF or DC glow discharge; and biasing of the substrate may be done with DC or RF sources (and such biasing may be used to shape the tip of the blade).

It should now be seen that this invention permits the strengthening of a thin blade while maintaining sharpness (that is, imparting stiffness and rigidity to the thin blade without ruining the acuteness or sharpness of the tip). Where a more conventional razor blade might be coated to a thickness in the order of a magnitude of about 100 to 350 angstroms, the method of this invention will deposit an amorphous diamond coat perhaps as high as 3,000 angstroms in thickness (as measured on the blade surface disposed away from the tip) and as high as 5,000 angstroms measured at the tip. As previously mentioned, all of this is achieved while maintaining a high aspect ratio.

It might be noted that the razor blades intended to be coated by this method are expected to be thinner than the usual razor blade, and sharper, and that the 2:1 and higher aspect ratios permitted by the process of this invention, coupled with the enormous strength of the amorphous diamond hard carbon coating, puts the blade in a class by itself.

The following, taken from above-mentioned US. Patent 5,480,527 describes the presently preferred filtered cathodic arc design and operation.

In the last decade or so, vacuum arc evaporation has come into wide commercial use for deposition of metal, alloy, and metal compound coatings on a substrate to be coated. Vacuum arc discharges have also been used as ion sources for such applications as ion implantation, beam accelerators, and rocket propulsion.

The process of vacuum arc evaporation for coating or implanting a substrate includes a cathode target composed of the material to be deposited, and a substrate which is to be coated. The target is vaporized by a high current, low voltage arc plasma discharge in a vacuum chamber which has been evacuated to a pressure of typically less than .001 mbar. The substrates to be coated or implanted are usually placed in the vacuum chamber facing the evaporable surface of the target, at a distance of typically 10-100 cm. Typical arc currents range between 25 and 1000 amperes, with voltages between 15 and 50 volts.

The arc plasma discharge conducts electric current between a cathode and an anode through the plasma created by vaporization and ionization of the target material by the arc. The cathode (negative electrode) is an electrically isolated source structure which is at least partially consumed during the process. The.consumable portion of the cathode is called the "target" and is often fabricated as a replaceable element clamped to a cooled, non-consumable element called the cathode body. The anode (positive electrode) may be an electrically isolated structure within the vacuum chamber or may be the vacuum chamber itself, and is not consumed in the process.

An arc is ignited on the evaporable surface of the cathode target, commonly by means of mechanical contact, high voltage spark, or laser irradiation. The ensuing arc plasma discharge is highly localized in one or more mobile arc spots on the cathode target surface, but is distributed over a large area at the anode. The extremely high current density in the arc spot at the cathode, estimated to be 10⁶-10⁸ amperes/cm², results in local heating, evaporation, and ionization of the cathode source material.

Each arc spot emits a jet of plasma in a direction approximately perpendicular to the cathode target surface, forming a luminous plume extending into the region between the cathode and anode. The substrate to be coated or implanted is placed between or adjacent to the cathode and anode. The vapor of cathode material is typically further accelerated toward the substrate surface by an applied voltage, and condenses onto or becomes imbedded into the surface of the substrate. Reactive gases may be introduced into the vacuum chamber during the evaporation process, resulting in the formation of material compounds involving the target material, reactive gas, and/or the substrate material.

Below about 70-100 amperes of arc current, depending on the target material, only a single arc spot exists on the surface of the cathode source material. At higher arc currents, multiple arc spots can exist simultaneously on the target surface, each carrying an equal fraction of the total arc current. An arc spot, in the absence of applied magnetic fields, tends to move randomly around the target surface, leaving a trail of microscopic crater-like features on the target surface.

An externally applied magnetic field exerts a force on the arc jet in a direction perpendicular to both the field lines and the jet, and can have a dominant influence on the large-scale average movement of the arc spot although the small-scale motion of the arc remains semi-random. The direction of the motion of the arc spot in a magnetic field is opposite or "retrograde" to the vector JxB direction expected based on Ampere's law, considering the electron current emitted from the cathode. This phenomenon is due to complex dynamic effects within the arc jet, and has been widely reported and discussed.

An undesirable side effect of the vaporization of the target material at the arc spot is the generation of droplets of molten target material, which are ejected from the target by reaction forces due to expansion of the vapor jet. These droplets are commonly called macroparticles, and range in diameter from sub-micron to tens of microns. The macroparticles can become imbedded in the coating when they land on the substrate to be coated, forming objectionable irregularities, or the macroparticles can stick to the substrate and later fall off, causing pits in the coating.

Various strategies have been devised to reduce the number of macroparticles incorporated into the coating on the substrate. These strategies fall generally into two categories: (1) a first category using some form of magnetic field to control and accelerate the arc, thus reducing macroparticle generation, and (2) a second category using a filtering apparatus between the cathode source and the substrate so as to transmit the ionized fraction of the cathode output to the substrate, but to block the molten droplets.

The magnetic methods of the first category are generally simpler than the filtering methods, but do not completely eliminate macroparticle generation. The filtering methods of the second category are generally more effective at removing macroparticles than the magnetic methods, but require complex apparatus and reduce the source output significantly.

Filtering methods work by placing the substrate out of the line of sight of the cathode target surface, so that macroparticles emitted from the cathode do not impinge directly on the substrate. An angled filtering duct is interposed between the cathode and the substrate to transport the plasma to the substrate.

In order to reach the substrate, the charged plasma emitted from the cathode source is deflected electromagnetically within the filtering duct through an angle of 45-180° so as to pass through the bend in the filtering duct and to impinge on the substrate. The uncharged macroparticles are not deflected by the electromagnetic field and continue in a course which hits the walls of the filtering duct so that ideally the macroparticles do not reach the substrate. In practice, however, bouncing of macroparticles off the filter walls and/or entrainment of small particles in the plasma can result in transmission of some macroparticles through the filter to reach the substrate.

Prior filtered cathodic arcs have been based upon circular or cylindrical cathode and filter geometry, generally limiting potential applications to small substrates or special shapes.

Examples of the early work done in the field of arc evaporation are described in several United States patents, including United States Patent No. 484,582 of Edison which describes the use of vacuum arc evaporation for depositing a coating onto a substrate; United States Patent No. 2,972,695 of Wroe which describes a magnetically stabilized vacuum arc evaporation apparatus; United States Patent Nos. 3,625,848 and 3,836,451 of Snaper which describe arc evaporation apparatus with particular electrode configurations, and the use of a magnetic field to increase the evaporation rate and to direct ions to the substrate; and United States Patent Nos. 3,783,231 and 3,793,179 of Sablev, et al. which describe particular configurations of electrodes and shields, and describe use of a magnetic field activated whenever the arc spot moves off the desired evaporation surface of the cathode source material.

Examples of cathodic arcs confined within a circular or racetrack path upon the cathode are illustrated by United States Patent Nos. 4,724,058 of Morrison; 4,673,477 of Ramalingam, et al.; and 4,849,088 of Veltrop, et al. Each of the foregoing publications describes an arc evaporation apparatus using an arched magnetic field in the shape of a closed loop tunnel, which confines the arc spot to a closed loop racetrack trajectory at a fixed or movable location on the cathode surface. Confinement and acceleration of the arc by the magnetic field is said to reduce generation of macroparticles by the arc discharge. The means required to generate such a magnetic field are widely known in the art of planar magnetron sputtering. It is also known, for example, to move the electro-magnetic field generating means of the arc, either mechanically as taught by Ramalingam, et al. and by Veltrop, et al., or by use of multiple electromagnets as taught by Morrison.

Examples of elongated, cylindrical cathodes are included in United States Patents 4,609,564 and 4,859,489 of Pinkhasov; 5,037,522 of Vergason; and 5,269,898 of Welty, all of which describe the use of an elongated cathode in the form of a cylinder or rod, and make use of the self-magnetic field of the arc current to force its motion along the length of the cathode. Welty teaches that macroparticle generation can be reduced by application of an additional axial magnetic field component to accelerate and control the arc motion.

United States Patent No. 4,492,845 of Kljuchko, et al. describes an arc evaporation apparatus using an annular cathode, and in which the evaporable cathode surface is its outer wall, facing a cylindrical anode of larger diameter and greater length than the cathode. The substrates to be coated are disposed inside the annular cathode, not facing the evaporable surface, and are coated by ionized material reflected back by the electromagnetic field at the anode. A coaxial magnetic field is described for enhancing the reflection from the anode. Macroparticles ejected from the cathode surface are not reflected electrically by the anode (although they may bounce off it mechanically). As a result, macroparticle incorporation in the coating is reduced.

Examples of efforts to reduce the number of macroparticles incorporated into the coating on the substrate by using some form of a filtering apparatus between the cathode source and the substrate to transmit the charged ionized fraction of the cathode output and to block the uncharged macroparticles are shown in work done by Aksenov/Axenov, Falabella and Sanders.

A publication by Aksenov, et al. ("Transport of plasma streams in a curvilinear plasma-optics system", Soviet Journal of Plasma Physics, 4(4), 1978) describes the use of a cylindrical plasma duct containing a 90 degree bend, with electromagnet coils to create a solenoidal magnetic field through the duct, and with a circular arc evaporation cathode at one end of the duct and a substrate at the other end. The plasma emitted by the cathode is reflected from the duct walls by the magnetic and electric fields present, and transported along the magnetic field through the duct to the substrate, while the uncharged macroparticles are not deflected by the magnetic or electrostatic fields and are intercepted by the duct walls.

United States Patent No. 5,279,723 of Falabella et al. describes an apparatus essentially similar to the original Aksenov filter, using a cylindrical duct with a 45 degree bend, a circular or conical cathode and anode, and including improvements to various components including the shape of the cathode and the internal baffles which reduce macroparticle transmission.

United States Patent No. 4,452,686 of Axenov et al. describes a straight cylindrical filtering duct with no bend, a circular cathode located at one end of the duct, electromagnet coils to generate a solenoidal magnetic field through the duct, and with an additional electrode located in the center of the duct which blocks direct line of sight deposition from the cathode to the substrate. Plasma emitted by the cathode is deflected by the magnetic and electric fields at the duct wall and central electrode, and transported along the magnetic field through the duct and around the central electrode. The uncharged macroparticles are not deflected by the magnetic or electric fields and are intercepted by the central electrode.

United States Patent No. 5,282,944 of Sanders, et al. describes a device somewhat similar to that of 4,452,686 of Axenov, using a straight cylindrical filtering duct and a central shield which prevents macroparticles emitted at low angles from the cathode from reaching the substrate directly. Electromagnet coils generate a magnetic field within the duct which is substantially solenoidal near the duct wall. The evaporable surface of the cathode in this case is the outer surface of a short cylinder oriented coaxially with the filter duct, such that the plasma emitted from the cathode is directed radially at the outer wall of the filter duct and is deflected through approximately 90 degrees by the magnetic field and the electric field at the duct walls, and transported along the magnetic field to the end of the duct at which the substrate is located. Internal electrodes are disclosed to enhance deflection of the plasma at the end of the circular filtering duct opposite to the end at which the substrate is located.

None of the prior art publications disclose a cathode having an evaporable surface of rectangular shape and using magnetic field polarity reversal to control the movement of the arc on the cathode surface, nor is a filtering duct having rectangular cross section disclosed.

Rectangular deposition sources are desirable for the coating of large substrates, coating of sheet material in roll form, and for coating of continuous streams of smaller substrates on a linear conveyor or circular carousel. Development of rectangular planar magnetron sputtering cathodes in the 1970's has led to widespread commercialization of sputtering for the coating of substrates in such configurations (see, for example the magnetron sputtering cathode of Welty, United States Patent Nos. 4,865,708 and 4,892,633).

Filtered cathodic arc sources have the advantage that the stream of vapor of cathode material emitted from the source is fully ionized, unlike non-arc-based deposition methods such as evaporation and sputtering. The fully ionized vapor stream from a rectangular source would allow greater control over the energy of the atoms arriving at the substrate for coating or implantation, and would increase the reactivity of the vapor in forming compounds with reactive gases in the system, or with the substrate directly.

The hereinafter described design and operation provide the benefits of a filtered cathodic arc (fully ionized vapor stream, elimination of splattered droplets) and the benefits of a rectangular source (uniform evaporation from the source and uniform deposition on the substrate using linear motion) in order to coat or implant a long or large substrate.

The presently described design provides means to generate and direct a plasma beam over a rectangular area, for the purpose of forming a coating or performing ion implantation on a substrate. A rectangular cathode is mounted in an angled duct of rectangular cross section, which confines the plasma and deflects it toward the substrate region while intercepting the molten droplets of cathode material also generated by the arc. The region of the plasma duct in which the cathode is mounted is referred to herein as the entrance arm of the duct, while the substrate is mounted adjacent to the exit arm of the duct.

A magnetic field is created within the duct which directs the plasma through the duct while simultaneously causing the arc to move in one direction down the length of the rectangular cathode. When the arc reaches the end of the cathode, a sensor provides a signal upon which the polarity of at least a portion of the magnetic field is reversed, causing the arc to reverse direction and move toward the opposite end of the cathode. The polarity of the magnetic field is switched whenever the arc reaches either end of the cathode, thus scanning the arc back and forth along the length of the rectangular cathode.

Although the polarity (direction) of the magnetic field is reversed repetitively, the shape of the magnetic field and its orientation with respect to the duct preferentially remain substantially the same, and plasma is transmitted through the duct in either polarity. In a preferred embodiment of the invention, a region of converging magnetic field lines adjacent to the cathode forms a magnetic mirror which reflects plasma toward the exit of the duct.

The movement of the arc along the length of the cathode target is due to the component of the magnetic field adjacent to the target surface which is parallel to the plane of the target surface and perpendicular to the long axis of the rectangular target. For magnetic flux components in this orientation, two polarities (directions) are possible. When the field has one polarity the arc moves along the length of the cathode in the direction given by the retrograde JxB vector as described above. When the field has the opposite polarity, the arc moves along the length of the cathode in the opposite direction.

By reversing the polarity of the magnetic field based on signals from the sensors located at the ends of the cathode, while maintaining the orientation of the flux lines with respect to the target surface, the direction of the movement of the arc along the length of the cathode can be reversed periodically, causing the arc to scan back and forth along the length of the rectangular cathode along a relatively straight line.

The reversible magnetic field adjacent to the evaporable surface of the target, which causes the arc to move along the length of the target, may be generated using electromagnet coils located outside the duct or within the cathode body. It is known in the prior art to generate a reversible field using the self magnetic field of the arc current flowing through the rectangular cathode. For example, connecting the arc current simultaneously to both ends of the rectangular cathode and varying the fraction of the total current which flows to each end of the cathode, based on the signals from the sensors located at the ends of the cathodes, will generate a magnetic field component in the orientation required to cause the arc to move along the length of the cathode, as described in United States Patent No. 5,269,898 of Welty.

As the direction in which the majority of the arc current flows within the rectangular cathode is reversed based on signals from the sensors, the polarity (direction) of the magnetic field component parallel to the target surface also reverses, thus reversing the direction of arc travel along the length of the target. Likewise, as also described in United States Patent No. 5,269,898, the magnetic field component which causes the arc scanning may also be generated by passing a control current along the length of the cathode and reversing its direction based on the sensor signals, or by switching the arc current input from one end of the cathode to the other as described in United States Patent No. 5,037,522 of Vergason. No suggestion has been made in the prior art to generate the reversible magnetic field using magnetic means independent of currents flowing through the cathode itself.

Transport of the plasma through the duct is due primarily to the component of the magnetic field adjacent to the duct walls which is parallel to the plane of the walls and parallel to the axis of the duct. Diffusion of the electrons of the plasma through the magnetic field toward the duct walls creates an electric field component perpendicular to the duct wall which reflects the positively charged ions, thus allowing them to continue travel along the duct and around the bend in the duct. The uncharged macroparticles are not reflected and are therefore intercepted by the duct walls, or by baffles which may be mounted perpendicular to the duct wall and extending a short distance into the duct to reduce bouncing of the macroparticles off the duct walls. The polarity of the magnetic field components within the duct and adjacent to the duct walls is preferentially switched simultaneously with the polarity of the field component adjacent to the target surface which causes the arc scanning, such that the shape of the magnetic field throughout the duct remains the same despite the reversals in polarity. It is also within the scope of the presently used technique, however, to reverse the polarity of the field only in the region of the target surface while maintaining a static (non-reversing) magnetic field in the rest of the duct using electromagnets or permanent magnets. Variations in the net shape of the magnetic field in this latter case may cause periodic variations in transmission of plasma through the duct as a function of the reversal of the field near the target surface.

Since the plasma jet is emitted from the cathode primarily in the direction perpendicular to the evaporable surface, it tends to impinge on the duct wall most strongly in the region of the outer radius of the bend in the duct. In order to increase the transmission of plasma through the duct it is desirable to intensify the strength of the magnetic field in this region. An additional factor is that cathode target materials of differing atomic weight and melting point are emitted from the target with different velocities and kinetic energies. It is therefore desirable to vary the strength of the magnetic field, particularly in the region of the bend in the duct, to optimize the transmission for various materials. Accordingly, in a preferred embodiment a separate electromagnet coil is provided in the vicinity of the outer radius of the bend in the duct, opposite the evaporable surface of the target, in which the current may preferably be varied independent of the current in the other coils generating portions of the magnetic field in the duct.

It should be noted that in the prior art of cylindrical plasma ducts (or in the straightforward way that the prior art might have been extended to a rectangular duct), in which one or more electromagnet coils are disposed encircling the duct in order to create a solenoidal magnetic field through the duct, the wires comprising the coil(s) must necessarily be spaced more closely together at the inside radius of the bend in the duct than at the outside radius. This results in the magnetic field inside the duct having greater strength towards the inner radius of the duct where the wires are spaced more closely, and lower strength towards the outer radius of the duct where the arc plasma jet impinges. The prior art therefore teaches away from this aspect of the present invention, in which the magnetic field strength inside the duct at the outer radius of the bend can be strengthened to equal or exceed the field strength at the inner radius, in order to increase the transmission of plasma through the duct.

The electric field perpendicular to the duct wall, which reflects the positively charged ions from the duct wall in the prior art and in the aspects of the present invention described above, is created by diffusion of the plasma electrons transversely through a magnetic field substantially parallel to the filter duct walls. It is also possible to reflect ions away from duct wall by a second method, namely by creating near the wall a region in which the magnetic flux lines converge as they approach the wall in an approximately perpendicular direction, creating a region known as a magnetic mirror. Plasma electrons approaching the wall are reflected or retarded as they enter the region of converging flux lines, creating an electron density gradient resulting in an electric field which reflects the plasma ions as well. Magnetic mirrors are commonly used for plasma confinement in laboratory apparatus and other plasma devices.

The utility of a magnetic mirror field is disclosed in the present invention for the first time in the art of filtered vacuum-arc plasma sources. The need for the function provided by the mirror field is illustrated, for example, in the prior art illustrated by United States Patent No. 5,282,944 of Sanders, et al. in which a number of insulating rings, labeled 21 in Figures 2 and 3 thereof, are pointed out as necessary to prevent plasma loss to the duct walls in the areas where the magnetic field passes through the duct wall. The inclusion of a magnetic mirror field region in the entrance arm of a preferred embodiment of the present technique creates a preferred direction for plasma flow toward the exit arm of the duct, while simultaneously providing the magnetic field component (parallel to the surface of the target and perpendicular to its long axis) which causes the arc to move down the length of the target. Reversal of the polarity of the magnetic mirror field, and thus the field component parallel to the target surface, causes the direction of travel of the arc on the target surface to reverse without changing the shape or function of the mirror field.

The combination and superposition of independently variable magnetic field sources providing a solenoidal magnetic field region in the exit arm of the plasma duct, a "bumper" field region near the outer radius of the bend in the duct, and a magnetic mirror field region in the entrance arm of the duct adjacent to the cathode provide sufficient adjustability to allow optimization of plasma transport through the duct for a wide variety of target materials. It is to be understood, however, that not all of these elements need be present in an embodiment of the present technique, and that the elements present need not be independently variable, particularly in the case of a source which is optimized for a single target material. For example, depending on the method used for reversing the polarity of the magnetic field region near the target surface, a single solenoidal electromagnet surrounding the entire duct may be sufficient.

The present technique differs from the prior art in the rectangular shape of the cathode and plasma duct, in the method of control of arc movement on the cathode, and in the shape and control of the magnetic field in the plasma duct.

In particular, the disclosed magnetic field shape and control methods make it possible to construct a compact, efficient plasma source with a rectangular output aperture which can be made as long as desired, thus providing the benefits of a filtered cathodic arc in combination with the benefits of a rectangular deposition source. The field reversal technique for arc control on the cathode surface allows the width of the cathode to be made much smaller than is possible using the race-track-style magnetic filed of the prior art.

The plasma duct can therefore be made much narrower and shorter, resulting in a compact design which is easier to integrate into a vacuum system than the bulky filters of the prior art, particularly in systems containing multiple plasma sources. The narrow cathode and scanned arc also permit more uniform erosion of the target along its length and higher target material utilization than is possible with planar racetrack-style cathodes.

The advantages of the present technique permit the source to be extended indefinitely in length, thus providing the benefits of filtered arc deposition or implantation to applications requiring rectangular or extended vapor sources.

FIG. 1A is a schematic illustration of a prior art filtered vacuum arc using a circular cathode and a cylindrical plasma duct.

FIG. 2A is a schematic view of the filtered arc plasma source of the present technique.

FIG. 3A is a perspective view of the duct assembly and magnets of the present technique.

FIG. 4A is an end elevational cross section of the duct assembly of the present technique.

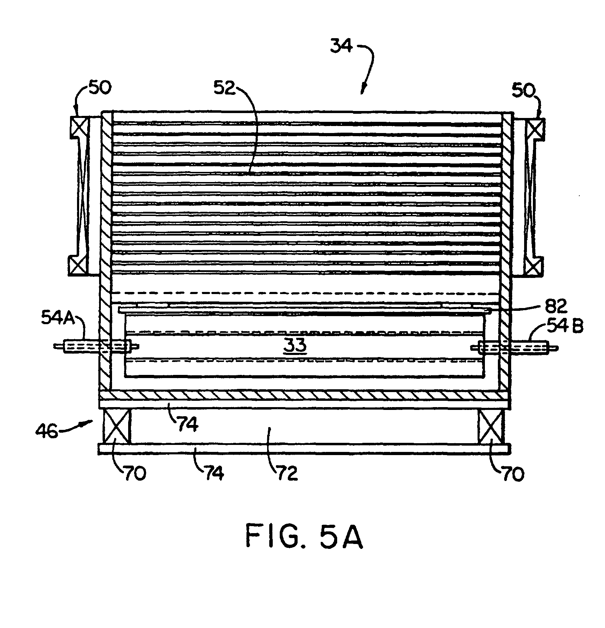

FIG. 5A is a side elevational cross section of the duct assembly of the present technique.

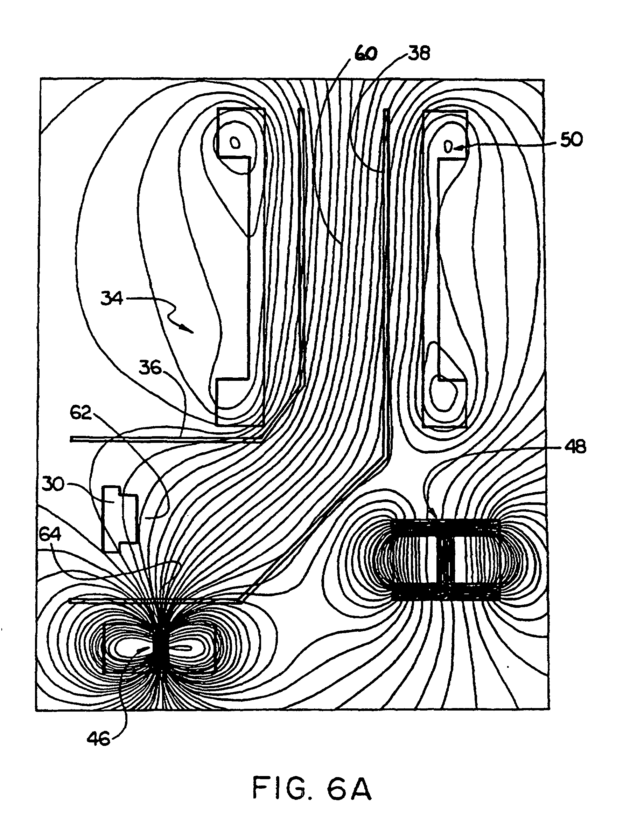

FIG. 6A is an end cut-away view showing the magnetic field lines and magnetic field mirror of the present technique in relation to the duct assembly and magnet sets thereof.

The present technique provides a way to generate and direct a plasma beam over a rectangular area for the purpose of forming a coating or performing ion implantation on a substrate.

FIG. 1A shows a prior art cathode 20 coupled to a filter 22 capable of separation of macroparticles from an ion flux produced by cathodic arc discharge. The cathode 20 is frustrum-shaped, having a circular face and tapered sides. The filter 22 includes two solenoids, end to end, but placed at a 45° angle to one another for preventing line of sight from an arc spot on the cathode to a substrate 24 to be coated while providing a path for the ions and electrons to flow, and it includes a series of baffles for trapping the macroparticles.

With reference to the schematic view of FIG. 2A one preferred embodiment of this invention can be understood to include a cathode target 30 on cathode body 31. Target 30 has an evaporable surface 33 of substantially rectangular shape. In a preferred embodiment, the cathode 30 is carbon, but it may be composed of any suitable evaporable material. The cathode body 31 is mounted on a holder 32 and situated in entrance arm 36 of plasma duct 34. Cathode 30 is connected to the négative output of an arc power supply 28, and plasma duct 34 (which also serves as an anode) is connected to the positive output of the arc power supply. An arc striker 35 is provided for igniting an arc discharge between cathode 30 and anode 34. Cathode 30 and evaporable surface 33 may also be surrounded by insulators 86 (reference FIG. 4A) An internal electrode 82 is mounted within the plasma duct 34, as is sensor 84.

Plasma duct 34 has a rectangular cross-sectional shape of similar dimensions to cathode 30. The plasma duct includes a bend in the axis along the centerline of the plasma duct. In the embodiment shown here, an equivalent inner radius bend point 37 is shown on one of the walls of the duct and is approximately 90°, but an inner radius angle in the range of approximately 15° to 120° is suitable for the practice of this invention. An equivalent outer radius bend is indicated generally at reference numeral 39. The plasma duct 34 has an entrance arm 36 and an exit arm 38 on either side of inner radius bend point 37. The cathode 30 is mounted on an isolated holder 32 at or near the end of the entrance arm so that the evaporable surface 33 of the cathode faces into the plasma duct. One or more substrates 44 to be coated may be located in an area at or near the end of exit arm 38.

A set of electromagnets is disposed about plasma duct 34. Magnet 46 is connected to coil power supply 52 and is located near the entrance arm 36 of the plasma duct. Magnet 48 is connected to coil power supply 52 and is located near the outer radius 39 of the bend in plasma duct 34. Magnet 50 is a solenoid connected to coil power supply 52 and it wraps around a portion of the exit arm 38 of the plasma duct. The perspective view of FIG. 3A shows magnets 46, 48 and 50 in relation to the plasma duct 34, with magnet 46 near the entrance arm 38, magnet 48 near the outer radius 39 of the bend, and magnet 50 coiled around the exit arm 38.

With reference to FIG. 4A, it may be understood that magnet 46 includes a coil 70 wrapped around a central pole 72 of magnetically permeable material, with end plates 74 attached to each end of the central pole. Likewise, magnet 48 includes a coil 76 wrapped around a central pole 78 of magnetically permeable material, with end plates 80 attached to each end of the central pole. In the embodiment shown, end plates 80 of magnet 48 are made of magnetically permeable material, while the end plates 74 of magnet 46 are made of nonpermeable material, in order to shape the magnetic field in the desired manner.

Again with reference to FIG. 2A, it may be seen that conduit 54 feeds water to the cathode 30. Plasma duct 34 and internal electrode 82 may also preferably be water cooled, but provisions for such cooling are not shown. A bias voltage may be applied to the substrate 44, and the substrate may be conventionally rotated and/or translated during deposition. In a preferred embodiment, the plasma duct 34 and substrate 44 are enclosed within a chamber (not shown) and a vacuum is drawn. In another preferred embodiment, the plasma duct 34 and cathode holder 32 of the duct are in vacuum, while the outside of the duct is at atmospheric pressure.

Proceeding to the cross sectional views of FIGS. 4A and 5A, which are numbered with the same reference numerals previously used, certain additional details of the system may now be understood. It may be seen that the bend in the plasma duct 34 serves to prevent a line-of-sight between the cathode 30 and the substrate 44 (not shown in FIGS. 4A or 5A, but understood to be located at or near the end of the exit arm 38 of the duct). The inside walls of the exit arm 38, the entrance arm 36 and the bend of the plasma duct 34 are preferentially lined with a number of spaced apart baffles 52 which are substantially perpendicular to the inside walls and substantially parallel to one another.

With reference to FIG. 4A, an electrically isolated internal electrode 82 may be seen mounted inside the plasma duct 34. It may be electrically floating with respect to the anode, or it may be biased positively with respect to the anode. With reference to FIG. 5A, a pair of sensors 54 are located adjacent to each end of the evaporable surface of cathode 30, with 54A adjacent the left end and 54B adjacent the right end.

The magnets 46, 48 and 50 generate a magnetic field represented by magnetic flux lines that may be better understood with reference to FIG. 6A. Magnetic flux lines 60 are oriented in a direction substantially parallel to the axis of plasma duct 34 within exit arm 38. Magnetic flux lines 62 are oriented in a direction substantially parallel to the evaporable surface 33 of cathode 30 within the region of the entrance arm 36 near the cathode. Magnetic flux lines converge at a region 64 within the entrance arm 36, forming a magnetic mirror adjacent to the evaporable surface 33 of cathode 30.

The representation of magnetic flux lines 60 shown in FIG. 6A was generated by a commercially available finite element magnetic analysis program. In the particular case shown, magnets 50 and 46 have 600 amp-turns, while magnet 48 has 200 amp-turns. In this case, the field strength in the center of the exit arm 38 of the duct is approximately 50 gauss. It can be Been in this case that the flux density (field strength) at the outer radius 39 of the bend in the duct is approximately equal to the flux density at the inner radius 37 of the bend. By adjusting the number of turns in coil 76 of magnet 48, or the current flowing through it (i.e., adjusting the amp-turns), the flux density at the outer radius 39 of the bend may be adjusted independently of the flux density elsewhere in the duct.

The sensors 54A and 54B (reference FIG. 5A) are able to sense an arc spot and to produce a signal whenever the arc spot approaches either the left or right end, respectively, of the cathode 30. Sensors 54 may, for example, consist of electrically isolated wires extending into the plasma duct 34, with the wires connected to the anode through a resistor (not shown) of, say, 1000 ohms, thus providing an electrical voltage whenever the arc approaches the wire. Alternatively, sensors 54 may comprise a light-sensitive diode which detects the optical emission from the arc jet, or a magnetic field detector which senses the magnetic field of the arc. The coil power supply 52 (reference FIG. 2A) has a switch capable of reversing the direction of current flow through the magnets, and it is connected by conventional control means (not shown) to the sensors 54 so as to actuate a magnetic field reversal. The magnetic field reversal can occur simultaneously in all of the magnets and will reverse the direction of the magnetic flux lines without substantially changing the shape of the flux lines or their orientation with respect to the plasma duct. Alternatively, only one or both of magnets 46 and magnet 48 may be reversed.

In a desirable configuration of the system (not separately shown), the magnets are powered independently by more than one coil power supply 52. The use of more than one coil power supply permits the current of the magnets to be varied independently of one another for adjusting the magnetic field strength independently in different parts of plasma duct 34. At the same time, the separate coil power supplies are each provided with control systems so that they all reverse the direction of current simultaneously upon actuation by a signal from sensors 54.

From the foregoing description, it may be readily understood that the system operates as follows.

Arc starter 35 ignites an arc discharge between cathode 30 and the plasma duct 34 which serves as the anode. The arc discharge originates in an arc spot on the evaporable surface of the cathode and generates a plasma containing an ionized vapor of the cathode material.

Plasma duct 34 directs the plasma generated by the arc discharge from the cathode to a substrate 44 to be coated and/or implanted and which is located at or near the exit arm 38 of the duct. The plasma duct 34 has a rectangular cross-sectional shape of similar dimensions to the cathode 30, and has a bend of approximately 15-180 degrees in the axis along its centerline (in the embodiment illustrated, the inner radius 37 of the bend is 90 degrees), with the entrance arm 36 and exit arm 38 separated from line-of-sight of one another by the bend. The cathode 30 is located at or near the end of entrance arm 36 with its evaporable surface facing into the plasma duct, and the substrate 44 is located in an area at or near the end of exit arm 38.

The magnets 46, 48 and 50 generate within the plasma duct 34 and over the evaporable surface of cathode 30 a magnetic field, which is represented by magnetic flux lines. Magnetic flux lines are oriented in a direction substantially parallel to the axis of duct 34 within exit arm 38. Magnetic flux lines are oriented substantially parallel to the evaporable surface of cathode 30 within the region of entrance arm 36 at or near the cathode. Magnetic flux lines also converge in a region within entrance arm 36 of plasma duct 34, forming a magnetic mirror adjacent and parallel to the rectangular cathode 30. The magnetic flux lines direct the ionized vapor through the bend in the plasma duct and urge the arc spot into a generally linear motion along the length of the evaporable surface 33 of the cathode 30. The magnetic mirror is oriented in a direction which reflects plasma towards the exit arm 38 of plasma duct 34.

The sensors 54 sense the arc spot, and produce a signal whenever the arc spot approaches either end of said evaporable surface. The signal from the sensors actuates a control system which reverses the current in the coil power supply 52, thereby reversing the direction of the magnetic flux lines without substantially changing the shape of the flux . lines or their orientation with respect to plasma duct 34. Thus, the arc spot is urged, not only to scan in a linear direction over the surface of the rectangular cathode 30, but to scan back and forth in a generally end to end path.

The inside walls of the plasma duct 34 are lined with baffles 52. Macroparticles are filtered by the bend in the duct, and the baffles serve to trap the macroparticles.

The system includes a long and narrow rectangular source and a relatively compact duct having a rectangular cross section of dimensions similar to the source. A compact duct is thereby created. For example, good results have been obtained using a cathode target approximately 30 centimeters long by 2.5 centimeters wide, or a ratio between the length and the width of about twelve to one. Because the rectangular cathode of this invention may be extended indefinitely, it is expected that even higher ratios are attainable.

Accordingly, it can be understood that this technique provides a way to generate and direct a plasma beam over a rectangular area, for the purpose of forming a coating or performing ion implantation on a substrate.

As has been explained, the benefits are realized by: (a) the rectangular shape of the cathode source material, (b) the rectangular cross sectional shape of the plasma duct, (c) the control of the arc movement on the cathode by reversing polarity of the magnetic field to cause the arc to scan generally in a linear direction back and forth across the length of the rectangular source, and (d) the shape and control of the magnetic field in the plasma duct.

In particular, the magnetic field shape and control of the arc upon the rectangular source make it possible to construct a compact, efficient plasma source with a rectangular output aperture which can be made as long as desired, thus providing the benefits of a filtered cathodic arc in combination with the benefits of a rectangular deposition source. The field reversal technique for arc control allows the width of the cathode source to be made much smaller than is possible using the racetrack-style magnetic field of the prior art.

The plasma filtering duct can therefore be made much narrower and shorter, resulting in a compact design which is easier to integrate into a vacuum system than the bulky filters of the prior art. The narrow cathode and narrow linearly scanning arc also permit more uniform erosion of the target along its length and results in higher source material utilization than is possible with planar racetrack-style cathodes.

The advantages permit the source to be extended indefinitely in length, thus providing the benefits of filtered arc deposition or implantation to applications requiring rectangular or extended vapor sources.

## Claims

1. A process for forming a razor blade wherein a layer of amorphous diamond (60) is deposited on a substrate (50), comprising the steps of:
(a) providing a substrate;
(b) forming a wedge-shaped sharpened edge on said substrate that has an included angle of less than thirty degrees and a tip (52) radius of less than 1,200 angstroms; and
**characterized by**
(c) depositing a layer (60) of amorphous diamond on said sharpened edge; applying an initial high bias to the substrate (50) during deposition, and then applying a second lower bias to the substrate during deposition.

2. The process of claim 1, wherein said substrate (50) is mechanically abraded in a sequence of honing steps to form said sharpened edge.

3. The process in claim 1, and further including the step of applying an adherent polymer coating (72) on said amorphous diamond coated cutting edge.

4. The process of claim 1, wherein said amorphous diamond coating (60) on said cutting edge has a thickness of at least 400 angstroms from the sharpened tip (52) of said substrate (50) to a distance of forty micrometers from the sharpened tip (52).

5. The process of claim 1, wherein said substrate is of metal and said amorphous diamond coating (60) is at least four times as hard as said metal substrate (50).

6. The process of claim 1, wherein said layer of amorphous diamond (60) is deposited by a technique selected from the group consisting of filtered cathodic arc, cathodic arc, anodic arc, plasma decomposition of hydrocarbon gases, sputter deposition with post-ionization by inductively coupled rf, laser ablation, laser absorptive wave deposition (LAWD) and ion beam deposition.

7. The process of claim 1, wherein said layer of amorphous diamond (60) is deposited in a vacuum or an argon atmosphere in an evacuated chamber (80) in which a graphite target (96) is located; said graphite target (96) is energized and an arc is struck on it to deposit said layer of amorphous diamond on said sharpened edge while a DC or RF bias is applied to said substrate (50).

8. The process of claim 1, wherein the angle of incidence between plasma beam and blade facet is no less than 32 degrees.

9. A process according to claim 1, **characterized by** depositing a layer of amorphous diamond on said first blade facet and second blade facet, while controlling the deposition so that the layer of amorphous diamond is deposited on the first blade facet and second blade facet at an approximately equal average rate of deposition.

10. The process of claim 9, wherein said amorphous diamond material (60) is deposited by cathodic arc.

11. The process of claim 9, wherein said amorphous diamond coating (60) on said wedge-shaped edge has a thickness of at least 400 angstroms.

12. The process of claim 11, and further including the step of applying an adherent polymer coating (72) on said amorphous diamond coating cutting edge.

13. The process of claim 12, wherein said amorphous diamond coating (60) on said cutting edge has a thickness of about 2000 angstroms.

14. The process of claim 1, wherein said layer of amorphous diamond (60) is deposited directly onto said substrate.

## Patentansprüche

1. Verfahren zur Formgebung einer Rasierklinge, wobei eine amorphe Diamantschicht (60) auf ein Substrat (50) abgeschieden wird, wobei das Verfahren die folgenden Schritte umfasst:
(a) Vorsehen eines Substrats;
(b) Formen einer keilförmigen geschärften Kante auf dem genannten Substrat mit einem Öffnungswinkel von weniger als dreißig Grad und einem Radius an der Spitze (52) von weniger als 1200 Angström; und
**gekennzeichnet durch**
(c) Abscheiden einer amorphen Diamantschicht (60) auf die genannte geschärfte Kante; Anlegen einer anfänglichen hohen Vorspannung an das Substrat (50) während der Abscheidung und folgendes Anlegen einer zweiten, niedrigeren Vorspannung an das Substrat während der Abscheidung.

2. Verfahren nach Anspruch 1, wobei das genannte Substrat (50) in einer Folge von Honschritten abgeschliffen wird, so dass die genannte geschärfte Kante gebildet wird.

3. Verfahren nach Anspruch 1 und ferner den Schritt des Auftragens einer anhängenden polymeren Beschichtung (72) auf der genannten mit amorphem Diamant beschichteten Schneidkante aufweist.

4. Verfahren nach Anspruch 1, wobei die genannte amorphe Diamantbeschichtung (60) auf der genannten Schneidkante eine Dicke von mindestens 400 Angström von der geschärften Spitze (52) des genannten Substrats (50) bis zu einer Entfernung von vierzig Mikrometern von der geschärften Spitze (52) aufweist.

5. Verfahren nach Anspruch 1, wobei das genannte Substrat aus Metall besteht, und wobei die genannte amorphe Diamantbeschichtung (60) viermal so hart ist wie das genannte Metallsubstrat (50).

6. Verfahren nach Anspruch 1, wobei die genannte amorphe Diamantschicht (60) durch eine Technik abgeschieden wird, die aus der Gruppe ausgewählt wird, die folgendes umfasst: gefilterte Kathodenzerstäubung durch Bogenentladung, Kathodenzerstäubung durch Bogenentladung, Anodenzerstäubung durch Bogenentladung, Plasmazersetzung von Kohlenwasserstoffgasen, Zerstäubungsbeschichtung mit Nachionisierung durch induktiv gekoppelte Hochfrequenz, Laserablation, laserabsorbierende Wellenabscheidung (LAWD für Laser Absorptive Wave Deposition) und Ionenstrahlabscheidung.

7. Verfahren nach Anspruch 1, wobei die genannte amorphe Diamantschicht (60) in einem Vakuum oder in einer Argonatmosphäre in einer entleerten Kammer (80) abgeschieden wird, in der sich ein Graphit-Target (96) befindet; wobei das genannte Graphit-Target (96) erregt wird, und wobei ein Bogen darauf auftrifft, um die genannte amorphe Diamantschicht auf der genannten geschärften Kante abzuscheiden, während eine Gleichstrom- oder Hochfrequenzvorspannung an das genannte Substrat (50) angelegt wird.

8. Verfahren nach Anspruch 1, wobei der Einfallswinkel zwischen dem Plasmastrahl und der Klingenfacette nicht kleiner ist als 32 Grad.

9. Verfahren nach Anspruch 1, **gekennzeichnet durch** das Abscheiden einer amorphen Diamantschicht auf die genannte erste Klingenfacette und eine zweite Klingenfacette, während die Abschneidung so geregelt wird, dass die amorphe Diamantschicht auf die erste Klingenfacette und die zweite Klingenfacette mit einer ungefähr übereinstimmenden Abscheidungsrate abgeschieden wird.

10. Verfahren nach Anspruch 9, wobei das genannte amorphe Diamantmaterial (60) durch Kathodenzerstäubung durch Bogenentladung abgeschieden wird.

11. Verfahren nach Anspruch 9, wobei die genannte amorphe Diamantbeschichtung (60) auf der genannten keilförmigen Kante eine Dicke von mindestens 400 Angström aufweist.

12. Verfahren nach Anspruch 11, wobei das Verfahren ferner den Schritt des Auftragens einer polymeren Beschichtung (72) auf die genannte amorphe Diamantbeschichtungs-Schneidkante aufweist.

13. Verfahren nach Anspruch 12, wobei die genannte amorphe Diamantbeschichtung (60) auf der genannten Schneidkante eine Dicke von etwa 2000 Angström aufweist.

14. Verfahren nach Anspruch 1, wobei die genannte amorphe Diamantschicht (60) direkt auf das genannte Substrat abgeschieden wird.

## Revendications

1. Procédé de formation d'une lame de rasoir sur laquelle une couche de diamant amorphe (60) est déposée sur un substrat (50), comprenant les étapes de :
(a) fourniture d'un substrat ;
(b) formation d'un bord aiguisé en forme de coin sur ledit substrat qui comprend un angle au sommet de moins de trente degrés et un rayon de bout (52) de moins de 1200 angströms ; et
**caractérisé par**
(c) le dépôt d'une couche de diamant amorphe (60) sur ledit coin aiguisé ; l'application d'une haute polarisation initiale au substrat (50) lors du dépôt, puis l'application d'une deuxième polarisation plus faible au substrat lors du dépôt.

2. Processus selon la revendication 1, dans lequel ledit substrat (50) est abrasé mécaniquement selon une séquence d'étapes d'affûtage pour former ledit coin aiguisé.

3. Processus selon la revendication 1, comprenant en outre l'étape d'application d'un revêtement de polymère adhérant (72) sur ledit bord tranchant revêtu de diamant amorphe.

4. Processus selon la revendication 1, dans lequel le revêtement de diamant amorphe (60) dudit bord tranchant à une épaisseur d'au moins 400 angstrôms depuis l'embout aiguisé (52) dudit substrat (50) sur une distance de quarante micromètres depuis l'embout aiguisé (52).

5. Processus selon la revendication 1, dans lequel ledit substrat est métallique et ledit revêtement de diamant amorphe (60) est au moins quatre fois plus dur que ledit substrat métallique (50).

6. Processus selon la revendication 1, dans lequel ladite couche de diamant amorphe (60) est déposée par une technique sélectionnée dans le groupe constitué d'un arc cathodique filtré, d'un arc cathodique, d'un arc anodique, d'une décomposition au plasma de gaz d'hydrocarbures, d'une pulvérisation cathodique avec post-ionisation rf par couplage inductif, d'une ablation au laser, d'un dépôt par ondes absorbantes laser (LAWD) et d'un dépôt par faisceau ionique.

7. Processus selon la revendication 1, dans lequel ladite couche de diamant amorphe (60) est déposée dans une atmosphère sous vide ou d'argon dans une chambre évacuée (80) dans laquelle se trouve une cible en graphite (96) ; ladite cible en graphite (96) étant sous tension et soumise à un arc afin de déposer une couche de diamant amorphe sur ledit coin aiguisé en appliquant une polarisation DC ou RF audit substrat (50).

8. Processus selon la revendication 1, dans lequel l'angle d'incidence entre le rayon de plasma et la facette de la lame ne dépasse pas 32 degrés.

9. Processus selon la revendication 1, **caractérisé par** le dépôt d'une couche de diamant amorphe sur ladite première facette de lame et ladite deuxième facette de lame, tout en contrôlant le dépôt de telle sorte que la couche de diamant amorphe est déposée sur la première facette de lame et la deuxième facette de lame à peu près à la même vitesse moyenne de dépôt.

10. Processus selon la revendication 9, dans lequel ledit matériau de diamant amorphe (60) est déposé par arc cathodique.

11. Processus selon la revendication 9, dans lequel ledit revêtement de diamant amorphe (60) déposé sur ledit bord en forme de coin a une épaisseur d'au moins 400 angstrôms.

12. Processus selon la revendication 11, comprenant en outre l'étape d'application d'un revêtement de diamant amorphe adhérent (72) sur ledit bord tranchant à revêtement de diamant amorphe.

13. Processus selon la revendication 12, dans lequel ledit revêtement de diamant amorphe (60) déposé sur ledit bord tranchant a une épaisseur d'environ 2000 angstrôms.

14. Processus selon la revendication 1, dans lequel ladite couche de diamant amorphe (60) est déposée directement sur ledit substrat.
